# DEMANDE DE BREVET EUROPEEN

(11) **EP 4 576 182 A2**
(43) Date de publication de la demande: **25.06.2025**
(21) Numéro de dépôt: 24218553.6
(22) Date de dépôt: 10.12.2024
(51) Int. Cl.: H01L 21/683, H10H 20/00, H10H 20/818, H10H 20/819, H01L 23/544, H10H 20/01

(54) **PROCÉDÉ DE FABRICATION D'UN DISPOSITIF ÉLECTRONIQUE**

(30) Priorité: 22.12.2023 FR 2315024
(71) Demandeur: Aledia, 38800 Champagnier (FR)
(72) Inventeur: MAYER, Frédéric, 38430 MOIRANS (FR); BIETSCH, Alexander, 38330 MONBONNOT SAINT MARTIN (FR); CATELAIN, Thibault, 38000 GRENOBLE (FR); LOURO DE OLIVEIRA, Gabriel, 38320 BRIE ET ANGONNES (FR)
(74) Mandataire: Cabinet Beaumont

(57) **Abrégé**

La présente description concerne un procédé de fabrication d'un dispositif électronique (22), comprenant la formation, dans une première poignée (5) ayant des première et deuxième faces opposées (7), de rainures (8) dans la première face, la fixation de la première poignée (5) à une deuxième poignée (15) du côté de la première face, l'amincissement de la première poignée (5) du côté de la deuxième face (7), la fabrication d'une plaque (20) comprenant plusieurs exemplaires du dispositif électronique (22), la fixation de la plaque (20) à la deuxième face (7) de la première poignée (5), la formation de tranchées (32) dans la plaque (20) dans le prolongement des rainures (8), le retrait de la deuxième poignée (15), et la rupture de la première poignée (5) au fond des rainures (8) pour séparer les dispositifs électroniques (22).

## Description

### Domaine technique

La présente description concerne de façon générale les procédés de fabrication de dispositifs électroniques, notamment de dispositifs optoélectroniques comprenant des diodes électroluminescentes.

### Technique antérieure

Un exemple d'un procédé de fabrication d'un dispositif électronique comprend la formation, sur un support, d'une plaque comprenant plusieurs exemplaires du dispositif électronique suivie de la séparation des dispositifs électroniques. La séparation des dispositifs électroniques peut être réalisée par découpe de la plaque et du support, notamment par sciage. Un tel procédé de découpe peut être difficile à mettre en oeuvre lorsque les dispositifs électroniques occupent chacun une surface réduite.

Un procédé de séparation de dispositifs électroniques permettant d'obtenir des lignes de découpe de largeur réduite comprend la fragilisation locale du support par un traitement laser permettant la rupture du support par une action mécanique pour séparer les dispositifs électroniques. Un inconvénient est que le traitement au laser peut endommager les composants des dispositifs électroniques proches des lignes de découpe. Cet inconvénient peut être particulièrement prononcé lorsque les dispositifs électroniques comprennent chacun une pluralité d'éléments tridimensionnels semiconducteurs de taille nanométrique ou micrométrique, séparés par un matériau isolant électriquement. En effet, la taille des éléments tridimensionnels semiconducteurs et la distance séparant les éléments tridimensionnels semiconducteurs étant réduites, la dissipation thermique de la chaleur apportée par le traitement au laser peut entraîner un endommagement des éléments tridimensionnels semiconducteurs proches des lignes de découpe.

### Résumé de l'invention

Un mode de réalisation pallie tout ou partie des inconvénients des procédés de fabrication de dispositifs électroniques connus.

Un objet d'un mode de réalisation est que les composants des dispositifs électroniques proches des lignes de découpe ne soient pas endommagés.

Un mode de réalisation prévoit un procédé de fabrication d'un dispositif électronique comprenant les étapes suivantes :
- formation, dans une première poignée ayant des première et deuxième faces opposées, de rainures dans la première face ;
- fixation de la première poignée à une deuxième poignée du côté de la première face ;
- amincissement de la première poignée du côté de la deuxième face ;
- fabrication d'une plaque comprenant plusieurs exemplaires du dispositif électronique ;
- fixation de la plaque à la deuxième face de la première poignée ;
- formation de tranchées dans la plaque dans le prolongement des rainures ;
- retrait de la deuxième poignée ; et
- rupture de la première poignée au fond des rainures pour séparer les dispositifs électroniques.

De façon avantageuse, la première poignée est amincie pour en faciliter la rupture. De plus, de façon avantageuse, les étapes de formation des rainures et d'amincissement de la première poignée ne détériorent pas les dispositifs électroniques de la plaque puisque ces étapes sont réalisées avant la fixation de la plaque à la première poignée. En outre, la fixation de la plaque à la deuxième face de la première poignée obtenue étant réalisée après amincissement de la première poignée, il peut alors être obtenu plus facilement, à la fin de l'étape d'amincissement, un état de surface de la deuxième face adapté pour l'étape de fixation de la plaque à la première poignée. Un meilleur contrôle de la qualité de la fixation de la plaque à la première poignée peut de façon avantageuse être obtenu. De plus, la formation des tranchées dans la plaque dans le prolongement des rainures, et la rupture de la première poignée au niveau des tranchées facilite la séparation des dispositifs électroniques sans détérioration des composants électroniques des dispositifs électroniques.

Selon un mode de réalisation, les rainures sont formées par gravure par laser. De façon avantageuse le traitement au laser ne détériore pas les composants électroniques des dispositifs électroniques puisque réalisé avant la fixation de la plaque à la première poignée.

Selon un mode de réalisation, la fixation de la première poignée à la deuxième poignée est réalisée par collage par une première couche de colle. La première couche de colle permet avantageusement la réalisation d'un collage temporaire entre la première poignée et la deuxième poignée. Ceci signifie que la première poignée est fixée à la deuxième poignée par la couche de colle et peut ensuite être facilement détachée de la deuxième poignée. De façon avantageuse, la première couche de colle est située du côté de la première face de la première poignée alors que l'étape d'amincissement de la première poignée est réalisée du côté de la deuxième face de la première poignée. La première couche de colle ne gêne pas la mise en oeuvre de l'étape d'amincissement. En particulier, la première couche de colle ne gêne pas le fonctionnement d'un outil de meulage ou de polissage utilisé lors de l'étape d'amincissement et est compatible avec les techniques d'amincissement de sorte à maintenir le collage. Il peut alors être obtenu plus facilement, à la fin de l'étape d'amincissement, un état de surface de la deuxième face adapté pour l'étape de fixation, par exemple par collage, de la plaque à la première poignée. Un meilleur contrôle de la qualité de la fixation, par exemple par collage, de la plaque à la première poignée peut de façon avantageuse être obtenu.

Selon un mode de réalisation, l'étape de retrait de la deuxième poignée comprend en outre une étape de retrait, total ou partiel, de la première couche de colle.

Selon un mode de réalisation, la fixation de la plaque à la première poignée est réalisée par collage par une deuxième couche de colle. Selon les applications envisagées, le collage entre la plaque et la première poignée est un collage permanent. Les propriétés de la deuxième couche de colle peuvent donc être différentes des propriétés de la première couche de colle.

Selon un mode de réalisation, les tranchées s'étendent en outre dans la deuxième couche de colle.

Selon un mode de réalisation, la fixation de la plaque à la première poignée est réalisée par collage moléculaire. Ceci permet de façon avantageuse d'éviter la présence de la deuxième couche de colle

Selon un mode de réalisation, les tranchées sont formées par gravure de la plaque par gravure sèche ou gravure humide.

Selon un mode de réalisation, l'étape de fixation de la plaque à la première poignée comprend une étape de positionnement de premières marques de la première poignée par rapport à des deuxièmes marques de la plaque, de sorte que chaque dispositif électronique à séparer est positionné entre quatre rainures parmi les rainures.

Selon un mode de réalisation, la première poignée est au moins en partie en verre, en quartz, ou en saphir.

Selon un mode de réalisation, en projection dans un plan parallèle à la deuxième face, l'une des rainures est située entre chaque paire de dispositifs électroniques adjacents.

Un mode de réalisation prévoit également une structure comprenant :
- une première poignée ayant des première et deuxième faces et des rainures dans la première face ;
- une plaque comprenant plusieurs exemplaires d'un dispositif électronique fixée à la première poignée du côté de la deuxième face ; et
- une deuxième poignée fixée à la première poignée du côté de la première face.

Selon un mode de réalisation, la structure comprend en outre une première couche de colle entre la première poignée et la deuxième poignée.

Selon un mode de réalisation, la structure comprend en outre une deuxième couche de colle entre la plaque et la première poignée.

Selon un mode de réalisation, en projection dans un plan parallèle à la deuxième face, l'une des rainures est située entre chaque paire de dispositifs électroniques adjacents.

Selon un mode de réalisation, les rainures délimitent des plots dans la première poignée, chaque plot étant en regard d'un seul des dispositifs électroniques.

Un mode de réalisation prévoit également un système électronique comprenant un dispositif électronique ayant une première paroi latérale et un bloc ayant des première et deuxième faces opposées et une deuxième paroi latérale, le dispositif électronique étant fixé à la deuxième face, le système électronique comprenant en outre des flancs contenant la première paroi latérale, la deuxième paroi latérale et une partie reliant la première paroi latérale à la deuxième paroi latérale en saillie par rapport à la première paroi latérale et par rapport à la deuxième paroi latérale.

Selon un mode de réalisation, le dispositif électronique comprend des diodes électroluminescentes. La formation des rainures n'entraine pas, de façon avantageuse, une détérioration des diodes électroluminescentes voisines des lignes de découpe souhaitées.

Selon un mode de réalisation, chaque diode électroluminescente comprend un élément tridimensionnel semiconducteur de taille nanométrique ou micrométrique, correspondant à un microfil, un nanofil ou une structure de taille nanométrique ou micrométrique de forme pyramidale, et une couche active recouvrant l'élément tridimensionnel semiconducteur.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A, la figure 1B, la figure 2A, la figure 2B, la figure 3, la figure 4, la figure 5, la figure 6, la figure 7, la figure 8, la figure 9 et la figure 10 sont des vues en coupe, partielles et schématiques, de la structure obtenue à des étapes d'un mode de réalisation d'un procédé de fabrication d'un dispositif électronique, la figure 1B étant analogue à la figure 1A et illustrant une variante, et la figure 2B étant analogue à la figure 2A et illustrant une variante ;
la figure 11 est une vue en coupe, partielle et schématique, d'un système électronique comprenant le dispositif électronique obtenu selon le mode de réalisation du procédé de fabrication illustré sur les figures 1 à 10 ;
la figure 12, la figure 13 et la figure 14 sont des vues en coupe, partielles et schématiques, de structures obtenues à des étapes d'un autre mode de réalisation d'un procédé de fabrication d'un dispositif électronique ;
la figure 15 est une vue en coupe, partielle et schématique, de la structure obtenue à une étape d'un autre mode de réalisation d'un procédé de fabrication d'un dispositif électronique ;
la figure 16 est une vue en coupe, partielle et schématique, de la structure obtenue à une étape d'un autre mode de réalisation d'un procédé de fabrication d'un dispositif électronique ;
la figure 17 est une vue en coupe, partielle et schématique, d'un mode de réalisation d'un support ;
la figure 18, la figure 19, la figure 20, la figure 21, la figure 22, la figure 23, la figure 24, la figure 25, la figure 26, la figure 27, la figure 28, la figure 29, et la figure 30 sont des vues en coupe, partielles et schématiques, de structures obtenues à des étapes d'un mode de réalisation d'un procédé de fabrication d'un dispositif optoélectronique comprenant des diodes électroluminescentes ; et
la figure 31 la figure 32 et la figure 33 sont des vues en coupe, partielles et schématiques, de modes de réalisation de diodes électroluminescentes.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des figures.

Sauf précision contraire, les expressions "environ", "approximativement", "sensiblement", et "de l'ordre de" signifient à 10 % près, de préférence à 5 % près. Dans le cas d'angle, les expressions "environ", "approximativement", "sensiblement", et "de l'ordre de" signifient à 10 ° près, de préférence à 5 ° près. En outre, on considère ici que les termes "isolant" et "conducteur" signifient respectivement "isolant électriquement" et "conducteur électriquement".

Par dispositifs optoélectroniques, on entend des dispositifs adaptés pour effectuer la conversion d'un signal électrique en un rayonnement électromagnétique ou inversement, et notamment des dispositifs dédiés à la détection, la mesure où l'émission d'un rayonnement électromagnétique.

La transmittance d'une couche correspond au rapport entre l'intensité du rayonnement sortant de la couche par une face de sortie et l'intensité du rayonnement entrant dans la couche par une face d'entrée opposée à la face de sortie. Dans la suite de la description, une couche ou un film est dit opaque à un rayonnement lorsque la transmittance du rayonnement au travers de la couche ou du film est inférieure à 10 %. Dans la suite de la description, une couche ou un film est dit transparent à un rayonnement lorsque la transmittance du rayonnement au travers de la couche ou du film est supérieure à 10 %.

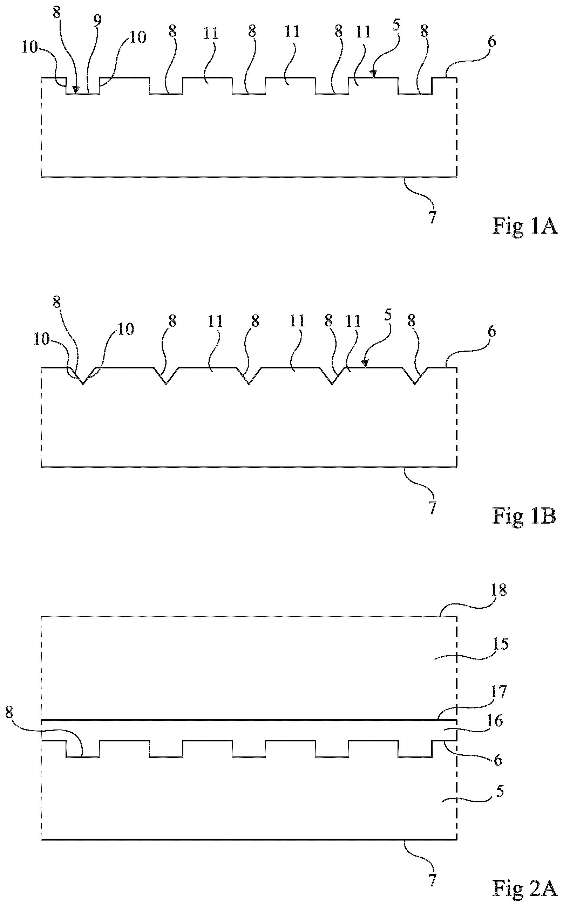

La figure 1A, la figure 2A, la figure 3, la figure 4, la figure 5, la figure 6, la figure 7, la figure 8, la figure 9 et la figure 10 sont des vues en coupe, partielles et schématiques, de la structure obtenue à des étapes d'un mode de réalisation d'un procédé de fabrication d'un dispositif électronique.

La figure 1A est une vue en coupe, partielle et schématique, de la structure obtenue après une étape de formation dans une première poignée 5, comprenant deux faces 6, 7 opposées, de rainures 8 s'étendant depuis la face 6, huit rainures 8 étant représentées à titre d'exemple en figure 1A. Selon un mode de réalisation, les faces 6 et 7 sont parallèles. Selon un mode de réalisation, les faces 6 et 7 sont planes. Selon un mode de réalisation, l'épaisseur de la première poignée 5, en dehors des rainures 8, est comprise entre 50 µm et 3 mm. Selon un mode de réalisation, la première poignée 5 a une structure monocouche ou multicouche. Selon un mode de réalisation, la première poignée 5 est transparente à la lumière visible. Selon un mode de réalisation, la première poignée 5 est en verre, en quartz, ou en saphir. Selon un mode de réalisation, les rainures 8 sont rectilignes.

Chaque rainure 8 est caractérisée par une profondeur et une largeur. Elle comprend typiquement un fond 9 et des parois latérales 10. Selon la section de la rainure 8, le fond 9 peut être arrondi ou même disparaître si les parois latérales 10 se retrouvent en forme de "V". Selon un mode de réalisation, chaque rainure 8 s'étend dans la première poignée 5, depuis la face 6 de la première poignée 5, sur une profondeur comprise entre 5 µm et 200 µm, par exemple égale à environ 30 µm. Selon un mode de réalisation, chaque rainure 8 a une largeur comprise entre 1 µm et 100 µm.

La figure 1B est une figure analogue à la figure 1A et illustre des rainures 8 ayant chacune une section droite en forme de "V" avec des parois latérales 10 inclinées.

Les rainures 8 délimitent des plots 11 dans la première poignée 5 séparés les uns des autres.

Selon un mode de réalisation, les rainures 8 sont formées par gravure laser, par gravure chimique (par voie humide ou voie sèche), par sciage mécanique ou par une combinaison de ces différentes techniques. Selon un mode de réalisation, la longueur d'onde du faisceau laser utilisé pour graver les rainures 8 est comprise entre 100 nm et 3000 nm en fonction du matériau à graver. Selon un mode de réalisation, le faisceau laser est émis sous la forme d'une impulsion, de deux impulsions ou plus de deux impulsions, chaque impulsion ayant une durée comprise entre 0,1 ps et 1000 ps. L'énergie du faisceau laser pour chaque impulsion est comprise entre 1 pJ et 100 pJ.

La figure 2A est une vue en coupe, partielle et schématique, de la structure obtenue après la fixation d'une deuxième poignée 15 à la première poignée 5 par l'intermédiaire d'une couche de colle 16 qui permet un collage temporaire de la deuxième poignée à la première poignée. Ceci signifie que la première poignée 5 est fixée à la deuxième poignée 15 par la couche de colle 16 et peut ensuite être facilement détachée de la deuxième poignée 15. La deuxième poignée 15 est fixée à la première poignée 5 du côté de la face 6, c'est-à-dire du côté des rainures 8. Selon un mode de réalisation, la colle pénètre dans les rainures 8. La deuxième poignée 15 comprend deux faces 17, 18 opposées, la couche de colle 16 étant en contact physique direct avec la face 17. Selon un mode de réalisation, les faces 17 et 18 sont parallèles. Selon un mode de réalisation, les faces 17 et 18 sont planes. Selon un mode de réalisation, l'épaisseur de la deuxième poignée 15 est comprise entre 50 µm et 3 mm. Selon un mode de réalisation, la deuxième poignée 15 est en silicium ou autre matériau semiconducteur, en verre, en quartz ou en saphir.

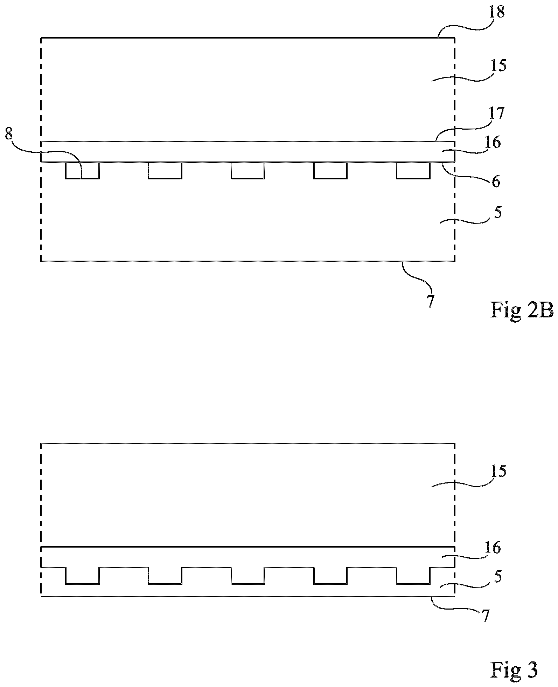

La figure 2B est une figure analogue à la figure 2A et illustre une variante selon laquelle la couche de colle 16 ne pénètre pas dans les rainures 8.

L'épaisseur de la couche de colle 16 est comprise entre 10 µm et 300 µm. Selon un mode de réalisation, la couche de colle 16 est en un matériau à matrice organique ou inorganique possédant des propriétés d'adhérence et des propriétés de décollement. Ce matériau peut être un composite, une couche unique ou un matériau multicouche.

La figure 3 est une vue en coupe, partielle et schématique, de la structure obtenue après une étape d'amincissement de la première poignée 5 depuis la face 7. Selon la nature du matériau ou des matériaux composant la première poignée 5, l'étape d'amincissement peut être réalisée par meulage et/ou par CMP (sigle anglais pour Chemical-Mechanical Polishing). L'étape de CMP peut comprendre, simultanément ou successivement, des étapes de polissage mécanique et des étapes de gravure chimique. A la fin de l'étape d'amincissement, l'épaisseur de la première poignée 5 est comprise entre 30 µm et 200 µm.

A la fin de l'étape d'amincissement, l'épaisseur de la première poignée 5 au fond de chaque rainure 8 est suffisamment faible pour permettre la mise en oeuvre d'une étape de rupture de la première poignée 5 au fond de chaque rainure 8 à une étape ultérieure du procédé décrite par la suite et est suffisamment élevée pour empêcher une rupture accidentelle de la première poignée 5 au fond de l'une des rainures 8 avant la mise en oeuvre de l'étape de rupture, même si la première poignée 5 peut être soumise à un fléchissement au cours des étapes du procédé.

De façon avantageuse, la couche de colle 16 est située du côté de la face 6 de la première poignée 5 alors que l'étape d'amincissement est réalisée du côté de la face 7 de la première poignée 5. La couche de colle 16 ne gêne pas la mise en oeuvre de l'étape d'amincissement. En particulier, la couche de colle 16 ne gêne pas le fonctionnement d'un outil de meulage ou de polissage utilisé lors de l'étape d'amincissement.

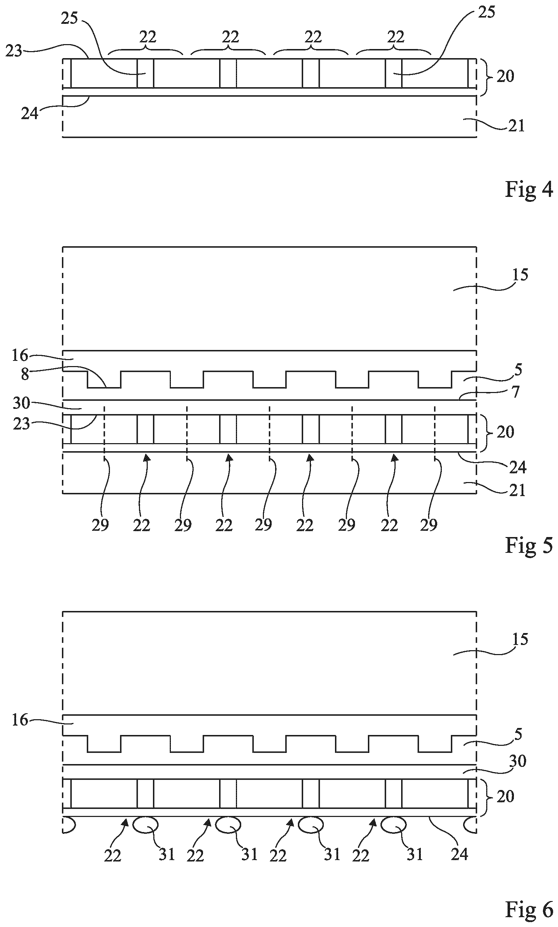

La figure 4 est une vue en coupe, partielle et schématique, de la structure obtenue après la fabrication d'une plaque 20 sur un substrat 21, la plaque 20 comprenant plusieurs exemplaires d'un dispositif électronique 22, quatre exemplaires du dispositif électronique 22 étant représentés en totalité à titre d'exemple en figure 4. La plaque 20 comprend une face supérieure 23 et une face inférieure 24, opposée à la face supérieure 23. La face inférieure 24 est en contact avec le substrat 21. La face supérieure 23 est de préférence plane. Selon un mode de réalisation, l'épaisseur de la plaque 20 est comprise entre 1 µm et 100 µm, de préférence entre 10 µm et 20 µm. Le dispositif électronique 22 comprend au moins un composant électronique 25, un seul composant électronique 25 étant représenté très schématiquement à titre d'exemple pour chaque dispositif électronique 22 en figure 4. Selon un mode de réalisation, le dispositif électronique 22 est un dispositif optoélectronique. Les composants électroniques 25 peuvent alors comprendre des sources de lumière, notamment des diodes électroluminescentes.

La figure 5 est une vue en coupe, partielle et schématique, de la structure obtenue après la fixation de la plaque 20 à la première poignée 5. Plus précisément, la face supérieure 23 de la plaque 20 est fixée à la face 7 de la première poignée 5, c'est-à-dire du côté opposé aux rainures 8. Selon un mode de réalisation, la plaque 20 est fixée à la première poignée 5 par l'intermédiaire d'une couche de colle 30. La couche de colle 30 est en matériau à matrice organique ou inorganique possédant des propriétés d'adhérence et des propriétés optiques permettant une transmission de la lumière dans le spectre visible, et est par exemple en matériau à base époxy, notamment une résine photosensible du type SU-8, une résine à base de benzocyclobutène (BCB), un adhésif optique commercialisé sous l'appellation NOA ou encore sous l'appellation IBA. Ce matériau peut être un composite, une couche unique ou un matériau multicouche. L'épaisseur de la couche de colle 30 est comprise entre 1 µm et 40 µm. Selon un mode de réalisation, la couche de colle 30 correspond à un adhésif optique. En particulier, lorsque le dispositif électronique 22 comprend une diode électroluminescente, la couche de colle 30 peut être transparente au rayonnement de la diode électroluminescente. Comme cela a été décrit précédemment, la couche de colle 16 ne gêne pas la mise en oeuvre de l'étape d'amincissement de la première poignée 5. Il peut alors être obtenu plus facilement, à la fin de l'étape d'amincissement, un état de surface de la face 7 adapté pour l'étape de fixation, par exemple par collage, de la plaque 20 à la première poignée 5. Un meilleur contrôle de la qualité de la fixation, par exemple par collage, de la plaque 20 à la première poignée 5 peut de façon avantageuse être obtenu.

Les rainures 8 sont situées dans le prolongement de lignes de découpe souhaitées entre les dispositifs électroniques 22. Les lignes de découpe sont indiquées schématiquement par des lignes 29 en traits tiretés en figure 5. Les lignes de découpe 29 souhaitées entre les dispositifs électroniques 22 et les rainures 8 sont superposées selon une direction orthogonale à la face 7, les lignes de découpe 29 souhaitées recouvrant les rainures 8 selon une direction orthogonale à la face 7. Autrement dit, les lignes de découpe 29 sont en regard du motif formé par les rainures 8 selon une direction orthogonale à la face 7. Les lignes de découpe 29 correspondent aux parties de la plaque 20 à retirer pour obtenir la séparation des dispositifs électroniques 22. Le positionnement correct de la plaque 20 par rapport à la première poignée 5 est obtenu en utilisant par exemple des marques sur la plaque 20 et des marques sur la première poignée 5 (les marques n'étant pas illustrées). Selon un mode de réalisation, en projection dans un plan parallèle à la face 7, le composant électronique 25 ou les composants électroniques 25 de chaque dispositif électronique 22 sont entourés par les rainures 8. Ceci signifie, en projection dans un plan parallèle à la face 7, une rainure 8 est située entre le composant électronique 25 ou les composants électroniques 25 de chaque dispositif électronique 22 de deux dispositifs électroniques 22 adjacents. Chaque plot 11 est ainsi en regard d'un seul des dispositifs électroniques 22.

La figure 6 est une vue en coupe, partielle et schématique, de la structure obtenue après le retrait du substrat 21 pour exposer la face inférieure 24 de la plaque 20 et après une étape de formations, sur la face 24 de la plaque 20, d'éléments de connexion électrique des dispositifs électroniques 22, par exemple des billes de soudure 31 ou des plots de connexion. L'étape de retrait du substrat 21 est réalisée par exemple par meulage, par gravure sèche, notamment une gravure plasma, ou par une gravure humide, ou par polissage mécano-chimique, appelée également CMP (sigle anglais pour Chemical-Mechanical Polishing).

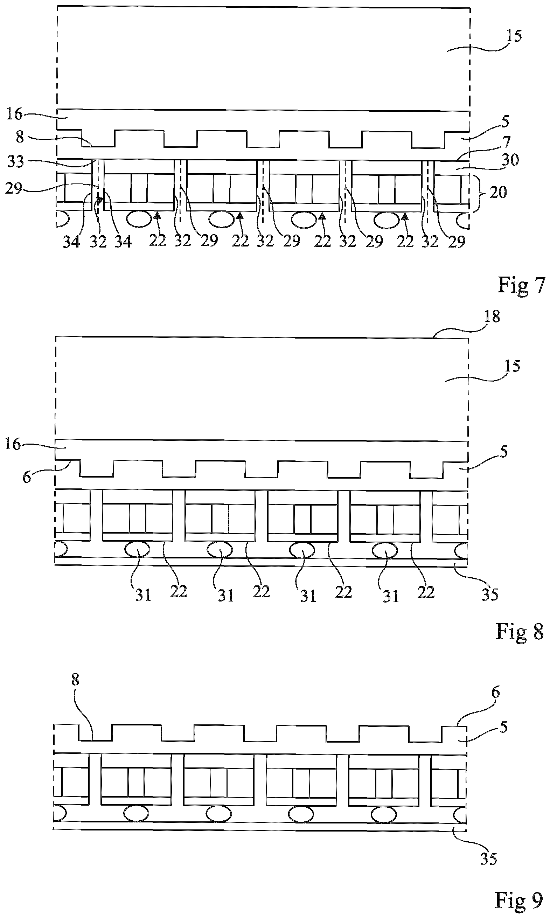

La figure 7 est une vue en coupe, partielle et schématique, de la structure obtenue après la formation de tranchées 32 dans la plaque 20, et éventuellement dans la couche de colle 30, pour délimiter les dispositifs électroniques 22 à séparer. Les tranchées 32 sont formées sur les lignes de découpe 29 souhaitées entre les dispositifs électroniques 22. Chaque tranchée 32 comprend un fond 33 et des parois latérales 34. Les tranchées 32 peuvent se prolonger dans la couche de colle 30 jusqu'à atteindre la face 7 de la première poignée 5. Selon un mode de réalisation, les tranchées 32 ne s'étendent pas dans la première poignée 5. Selon un mode de réalisation, le fond 33 de la tranchée 32 correspond à une portion de la face 7 de la première poignée 5. Selon un mode de réalisation, la profondeur de chaque tranchée 32 est comprise entre 10 µm et 80 µm. Selon un mode de réalisation, la largeur de chaque tranchée 32 est comprise entre 1 µm et 50 µm, de préférence entre 30 µm et 40 µm. Les tranchées 32 sont formées dans le prolongement des rainures 8. Ceci signifie que chaque tranchée 32 est alignée avec l'une des rainures 8. Selon un mode de réalisation, les tranchées 32 sont formées par gravure, par exemple par gravure sèche, notamment une gravure plasma, ou par sciage mécanique.

La figure 8 est une vue en coupe, partielle et schématique, de la structure obtenue après la fixation de la structure obtenue en figure 7 à un film adhésif 35, par exemple en matériau étirable, agencé du côté des billes de soudure 31. Selon un mode de réalisation, le film adhésif 35 est en un matériau compris dans le groupe comprenant les matériaux décrits dans les brevets US 4222913 et US 4379197, des résines polyéthylène sans groupe polymérisés d'acétate de vinyle, des polymères acrylate comme les composants suivants : 2-éthylhexyl acrylate, n-butyl acrylate, méthyl acrylate et t-butyl méthacrylate. On définit un matériau étirable comme étant un matériau dont le module de déformation longitudinale, c'est-à-dire le rapport entre la contrainte et l'allongement relatif, est compris entre 102 Pa et 106 Pa. De préférence, le film 35 est adapté à se déformer avec un allongement à la limite de rupture supérieur à 150 %, de préférence supérieur à 300 %.

La figure 9 est une vue en coupe, partielle et schématique, de la structure obtenue après le retrait de la deuxième poignée 15 et le retrait de la couche de colle 16 pour exposer la face 6 et les rainures 8 de la première poignée 5. A titre de variante, la couche de colle 16 peut ne pas être retirée complètement mais seulement partiellement. La première poignée 5 qui forme un écran continu joue de façon avantageuse un rôle de protection des dispositifs électroniques 22 lors du retrait de la deuxième poignée 15 et du retrait, total ou partiel, de la couche de colle 16.

Selon un mode de réalisation, le matériau composant la couche de colle 16 permet la réalisation d'un collage temporaire entre la première poignée 5 et la deuxième poignée 15. Ceci signifie que la liaison mécanique assurée par la couche de colle 16 entre la première poignée 5 et la deuxième poignée 15 peut être rompue par un traitement ne dégradant pas les autres éléments de la structure, notamment la première poignée 5, la deuxième poignée 15, et la plaque 20.

Selon un mode de réalisation, la deuxième poignée 15 est détachée de la première poignée 5 par retrait ou modification physico-chimique de la couche de colle 16. Selon un mode de réalisation, le retrait ou la modification physico-chimique de la couche de colle 16 est réalisée par une action mécanique, par exemple par la réalisation d'une découpe dans la couche de colle 16 au moyen d'une lame.

Selon un autre mode de réalisation, le retrait ou la modification physico-chimique de la couche de colle 16 est réalisée par dégradation du matériau composant la couche de colle 16. Selon un mode de réalisation, la dégradation du matériau composant la couche de colle 16 est réalisée par chauffage de la couche de colle 16. Selon un autre mode de réalisation, la dégradation du matériau composant la couche de colle 16 est réalisée par une action chimique sur la couche de colle 16, réalisée simultanément au chauffage de la couche de colle 16. Selon un autre mode de réalisation, la dégradation du matériau composant la couche de colle 16 est réalisée par exposition de la couche de colle 16 à un rayonnement, par exemple un rayonnement ultraviolet, infrarouge, ou de lumière visible, éventuellement d'une source de laser.

Selon un mode de réalisation, la deuxième poignée 15 est retirée par meulage et/ou par CMP (sigle anglais pour Chemical-Mechanical Polishing) de la deuxième poignée 15 depuis la face 18. La couche de colle 16 peut ensuite être retirée par utilisation d'un solvant, par gravure humide ou sèche, ou par incinération au plasma.

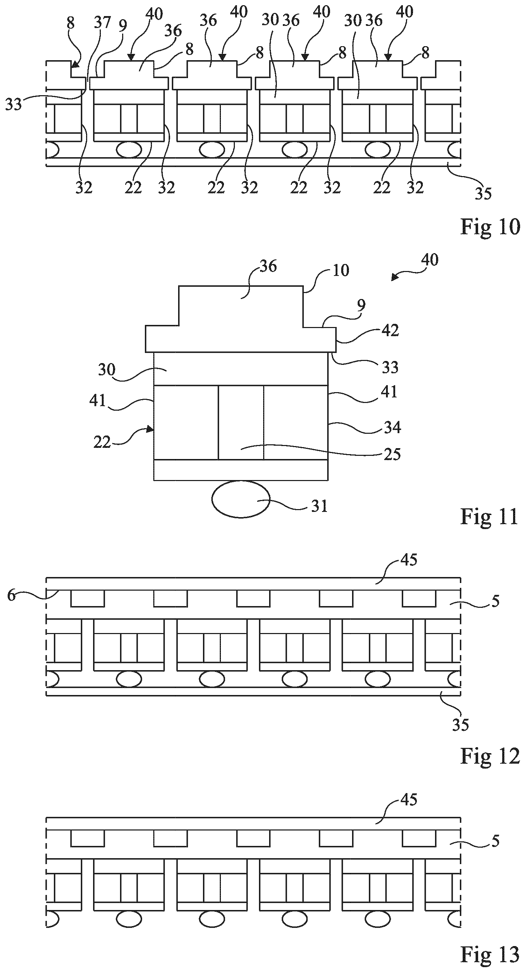

La figure 10 est une vue en coupe, partielle et schématique, de la structure obtenue après une rupture mécanique de la première poignée 5 depuis le fond 9 de chaque rainure 8. La rupture mécanique est réalisée par des dispositifs mécaniques qui réalisent la fracture entre les rainures 8 et les tranchées 32 dans la couche fine de matériau restant de la première poignée 5 entre le fond 9 des rainures 8 et le fond des tranchées 32. La première poignée 5 est alors séparée en blocs 36, chaque bloc 36 étant fixé à l'un des dispositifs électroniques 22. Les zones de rupture 37 s'étendent depuis le fond 9 de chaque rainure 8 jusqu'à la face 7 de la première poignée 5 dans le fond 33 de la tranchée 32 située dans le prolongement de la rainure 8. Il est ainsi obtenu des systèmes électroniques 40 séparés, chaque système électronique 40 comprenant le dispositif électronique 22 et le bloc 36 auquel il est fixé. Selon un mode de réalisation, l'étape de rupture comprend l'extension du film adhésif 35 dans le plan du film adhésif 35, les dispositif électroniques 22 étant alors séparés mais toujours fixés au film adhésif 35, le film adhésif 35 étant dans un état étiré, c'est-à-dire que des forces de traction sont exercées sur le film adhésif de telle manière que la surface du film adhésif étiré en vue de dessus corresponde de 150 % à 10000 % de la surface du même film adhésif sur lequel ne sont pas exercées de forces de traction. L'état étiré du film adhésif est maintenu par des moyens mécaniques.

Les systèmes électroniques 40 peuvent ensuite être manipulés séparément, par exemple par un système de triage et de préhension (en anglais: pick and place system), non représenté, et détachés du film adhésif 35.

Le procédé peut comprendre des étapes ultérieures, notamment une étape de retrait des blocs 36 et de la couche de colle 30 présente sous chaque dispositif électronique 22. Dans le cas où le bloc 36 est conservé pour l'utilisation future du dispositif électronique 22 et que le dispositif électronique 22 comprend une source lumineuse, le bloc 36 peut, de façon avantageuse, être transparent au rayonnement lumineux émis par le dispositif électronique 22.

Le mode de réalisation du procédé de fabrication permet de façon avantageuse que le traitement au laser de la première poignée 5 pour former les rainures 8 ne détériore pas les composants électroniques 25 de la plaque 20 puisque le traitement au laser de la première poignée 5 est réalisé avant la fixation de la plaque 20 à la première poignée 5.

La figure 11 est une vue en coupe, partielle et schématique, d'un système électronique 40 de la figure 10. Le système électronique 40 comprend le dispositif électronique 22 et le bloc 36 auquel il est fixé par une portion de la couche de colle 30. Le système électronique 40 comprend des flancs 41, chaque flanc 41 comprenant la paroi latérale 34 de la tranchée 32 ayant permis la délimitation du dispositif électronique 22, une partie du fond 33 de cette tranchée 32, une paroi latérale 10 de la rainure 8 qui était située dans le prolongement de la tranchée 32, une partie du fond 9 de la rainure 8, et une paroi 42 résultante de la rupture de la première poignée 5. Selon un mode de réalisation, la paroi 42 est en saillie latéralement par rapport à la paroi 34 du dispositif électronique 22. En outre, selon un mode de réalisation, la paroi 34 n'est pas coplanaire avec la paroi 10.

La figure 12, la figure 13 et la figure 14 sont des vues en coupe, partielles et schématiques, de structures obtenues à des étapes d'un autre mode de réalisation d'un procédé de fabrication d'un dispositif électronique.

Les étapes initiales sont les mêmes que celles décrites précédemment en relation avec les figures 1 à 9.

La figure 12 est une vue en coupe, partielle et schématique, de la structure obtenue après la fixation d'un film adhésif 45, en matériau étirable, à la structure obtenue en figure 9 du côté de la première poignée 5, plus précisément du côté de la face 6 de la première poignée 5.

La figure 13 est une vue en coupe, partielle et schématique, de la structure obtenue après le retrait du film adhésif 35.

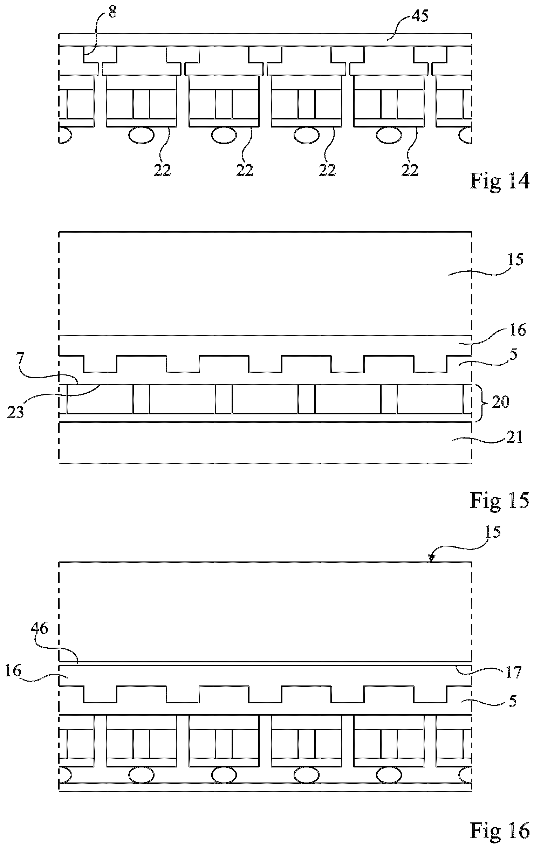

La figure 14 est une vue en coupe, partielle et schématique, de la structure obtenue après une rupture mécanique de la première poignée 5 dans le prolongement de chaque rainure 8. Des dispositifs électroniques 22 séparés sont ainsi obtenus. Selon un mode de réalisation, l'étape de rupture comprend l'extension du film adhésif 45 dans le plan du film adhésif 45, les dispositif électroniques 22 étant alors séparés mais toujours fixés au film adhésif 45 dans un état étiré. Comme cela a été décrit précédemment, les systèmes électroniques 40 peuvent ensuite être manipulés séparément, par exemple par un système de triage et de préhension (en anglais: pick and place system), non représenté, et détachés du film adhésif 45.

La figure 15 est une vue en coupe, partielle et schématique, de la structure obtenue à une étape d'un autre mode de réalisation d'un procédé de fabrication d'un dispositif électronique. Le procédé de fabrication selon le présent mode de réalisation comprend les étapes décrites précédemment en relation avec les figures 1 à 10 à la différence que la plaque 20 est fixée à la première poignée 5 par un collage moléculaire dans lequel la face 23 de la plaque 20 est mise en contact physique direct avec la face 7 de la première poignée 5 sans interposition d'un matériau supplémentaire de collage.

La figure 16 est une vue en coupe, partielle et schématique, de la structure obtenue à une étape d'un autre mode de réalisation d'un procédé de fabrication d'un dispositif électronique. Le procédé de fabrication selon le présent mode de réalisation comprend les étapes décrites précédemment en relation avec les figures 1 à 10 à la différence que la deuxième poignée 15 comprend une couche sacrificielle 46 du côté de la face 17, par exemple au contact de la couche de colle 16. A l'étape de retrait de la deuxième poignée 15, décrite précédemment en relation avec la figure 9, c'est la couche sacrificielle 46 qui est dégradée, par exemple par un traitement au laser, pour permettre le retrait de la deuxième poignée 15, et la couche de colle 16 est ensuite retirée, par exemple par gravure chimique.

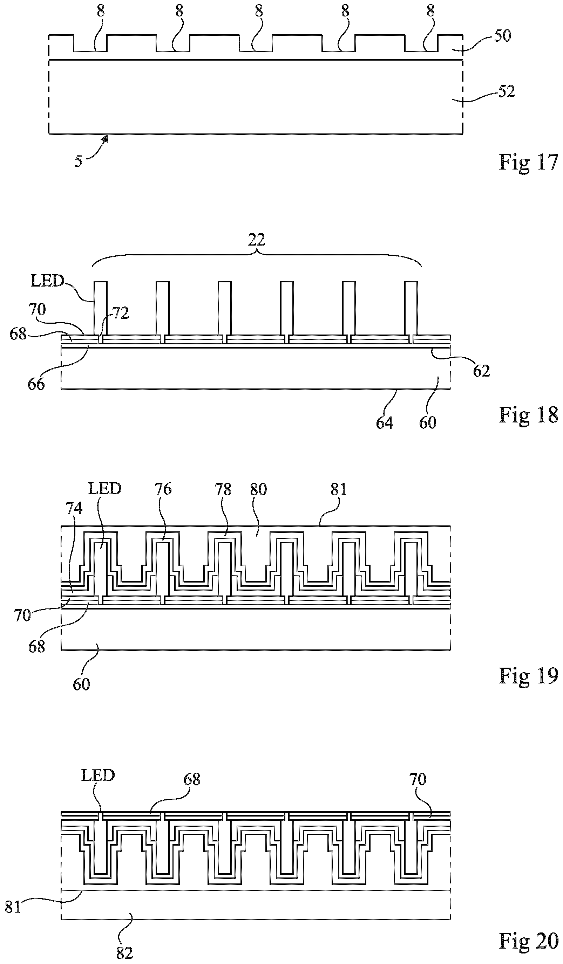

La figure 17 est une vue en coupe d'un mode de réalisation de la première poignée 5. Selon un mode de réalisation, la première poignée 5 a une structure multicouche et comprend une couche 50 d'un premier matériau recouvrant un substrat 52 en un deuxième matériau différent du premier matériau. Les rainures 8 sont formées dans la couche 50. Le substrat 52 peut être transparent au laser. Selon un mode de réalisation, le deuxième matériau est un matériau semiconducteur. Le matériau semiconducteur peut être du silicium, du germanium ou un mélange d'au moins deux de ces composés. De préférence, le substrat 52 est en silicium, plus préférentiellement en silicium monocristallin. A titre de variante, le substrat 52 peut être, au moins en partie, d'un matériau non semiconducteur, par exemple un matériau isolant électriquement ou un matériau conducteur électriquement. L'épaisseur de la couche 50 est comprise entre 50 µm et 200 µm. De façon avantageuse, le deuxième matériau composant le substrat 52 est choisi pour faciliter l'étape d'amincissement décrite précédemment en relation avec la figure 3. En particulier, la détermination de la fin de l'étape d'amincissement est facilitée puisqu'elle correspond au retrait complet du substrat 52. Selon un mode de réalisation, le premier matériau est transparent à la lumière visible. Selon un mode de réalisation, le premier matériau comprend le verre, le quartz, et le saphir.

Un mode de réalisation plus détaillé va maintenant être décrit dans le cas où le dispositif électronique 22 est un dispositif optoélectronique et les composants électroniques 25 comprennent des diodes électroluminescentes comportant des éléments tridimensionnels semiconducteurs de taille nanométrique ou micrométrique, notamment des microfils ou nanofils ou des structures de forme pyramidale recouvertes des couches actives. En effet, pour de tels dispositifs optoélectroniques 22, la réalisation de la séparation des dispositifs électroniques 22 en utilisant la formation de rainures que la plaque contenant les dispositifs électroniques 22 est fixée à la première poignée entraîne une détérioration importante des diodes électroluminescentes voisines des lignes de découpe souhaitées.

Le terme "microfil" ou "nanofil" désigne une structure tridimensionnelle de forme allongée selon une direction privilégiée dont au moins deux dimensions, appelées dimensions mineures, sont comprises entre 5 nm et 5 µm, de préférence entre 100 nm et 2 µm, plus préférentiellement entre 200 nm et 1,5 µm, la troisième dimension, appelée dimension majeure ou hauteur, étant supérieure ou égale à 1 fois, de préférence supérieure ou égale à 3 fois et encore plus préférentiellement supérieure ou égale à 5 fois, la plus grande des dimensions mineures. Dans certains modes de réalisation, la hauteur de chaque microfil ou nanofil peut être supérieure ou égale à 500 nm, de préférence comprise entre 1 µm et 50 µm. Dans la suite de la description, on utilise le terme "fil" pour signifier "microfil ou nanofil".

La section droite des fils peut avoir différentes formes, par exemple, une forme ovale, circulaire ou polygonale, notamment triangulaire, rectangulaire, carrée ou hexagonale. On comprendra que le terme "diamètre moyen" utilisé en relation avec une section droite d'un fil désigne une quantité associée avec l'aire du fil dans cette section droite, correspondant, par exemple, au diamètre du disque ayant la même aire que la section droite du fil.

Dans la suite de la description, le terme pyramide désigne une structure tridimensionnelle dont une partie est de forme pyramidale ou conique allongée. Cette structure pyramidale peut être tronquée, c'est-à-dire que le haut du cône est absent, laissant place à un plateau. La base de la pyramide est inscrite dans un carré dont la dimension des côtés est de 100 nm à 10 µm, préférentiellement entre 0,2 µm et 2 µm. Le polygone formant la base de la pyramide peut être un hexagone. La hauteur de la pyramide entre la base de la pyramide et le sommet ou le plateau sommital varie de 100 nm à 20 µm, préférentiellement entre 200 nm et 2 µm.

Dans la suite de la description, des modes de réalisation vont être décrits dans le cas d'un dispositif optoélectronique à diodes électroluminescentes comprenant des microfils ou nanofils. Toutefois, il est clair que ces modes de réalisation peuvent concerner un dispositif optoélectronique à diodes électroluminescentes comprenant des pyramides de taille micrométrique ou nanométrique.

Les fils comprennent en majorité, de préférence à plus de 60 % en masse, plus préférentiellement à plus de 80 % en masse, au moins un matériau semiconducteur. Le matériau semiconducteur peut être du silicium, du germanium, du carbure de silicium, un composé III-V, un composé II-VI ou une combinaison d'au moins deux de ces composés.

Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires. Le matériau semiconducteur des fils peut comporter un dopant, par exemple du silicium assurant un dopage de type N d'un composé III-N, ou du magnésium assurant un dopage de type P d'un composé III-N.

La figure 18, la figure 19, la figure 20, la figure 21, la figure 22, la figure 23, la figure 24, la figure 25, la figure 26, la figure 27, la figure 28, la figure 29, et la figure 30 sont chacune une vue en coupe, partielle et schématique, de la structure obtenue à une étape d'un mode de réalisation d'un procédé de fabrication du dispositif optoélectronique 22.

La figure 18, la figure 19, la figure 20, la figure 21, la figure 22, et la figure 23 illustrent la fabrication de la plaque 20 sur le substrat 21 dans le cas où la plaque 20 comprend plusieurs exemplaires du dispositif optoélectronique 22 à nanofils ou microfils.

La figure 18 est une vue en coupe, partielle et schématique, de la structure obtenue après les étapes suivantes :
- formation, sur un substrat 60 comprenant des faces opposées 62 et 64, la face 62 étant de préférence plane au moins au niveau des diodes électroluminescentes, d'une couche de germination 66 en un matériau favorisant la croissance de fils et disposée sur la face 62 ;
- formation d'un empilement de deux couches isolantes 68 et 70 recouvrant la couche de germination 66 et comprenant des ouvertures 72 exposant des portions de la couche de germination 66 ; et
- croissance, pour chaque ouverture 72, d'une diode électroluminescente LED en contact avec la couche de germination 66 au travers de l'ouverture 72, six diodes électroluminescentes LED d'un seul dispositif optoélectronique 22 étant représentées à titre d'exemple en figure 18, les diodes électroluminescentes LED étant agencées en ensembles de diodes électroluminescentes LED.

La figure 19 est une vue en coupe, partielle et schématique, de la structure obtenue après les étapes suivantes :
- formation d'une couche isolante 74 s'étendant sur les flancs latéraux d'une portion inférieure de chaque diode électroluminescente LED et s'étendant sur la couche isolante 70 entre les diodes électroluminescentes LED ;
- formation d'une couche 76 formant une électrode recouvrant chaque diode électroluminescente LED et s'étendant en outre sur la couche isolante 74 entre les diodes électroluminescentes LED ;
- formation d'une couche diélectrique de protection 78 s'étendant sur la couche 76 ; et
- formation d'une couche 80 de planarisation s'étendant sur la couche 78 et ayant une face libre 81 plane.

La figure 20 est une vue en coupe, partielle et schématique, de la structure obtenue après les étapes suivantes :
- fixation d'une poignée 82 à la face 81 ; et
- retrait du substrat 60, et de la couche de germination 66, par tout moyen connu.

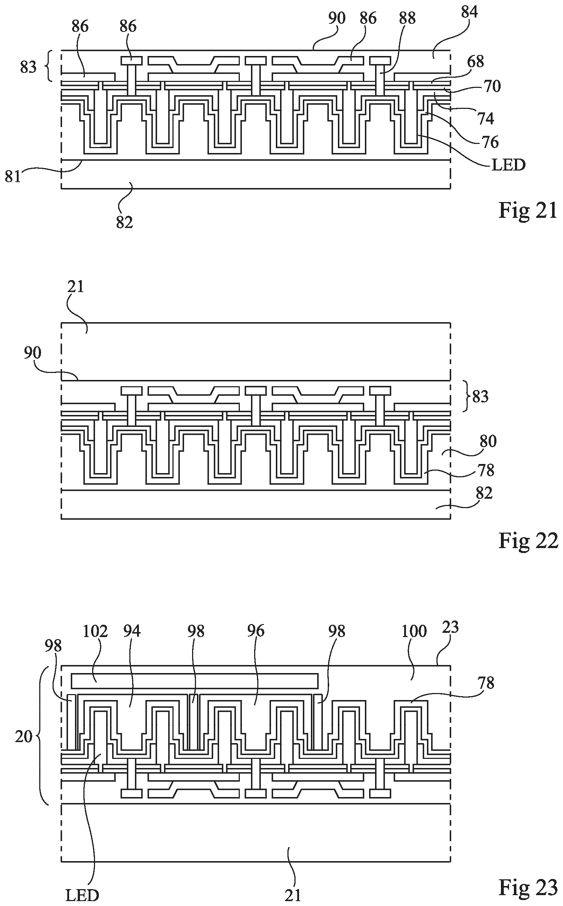

La figure 21 est une vue en coupe, partielle et schématique, de la structure obtenue après la formation, sur la couche isolante 68, d'une structure d'interconnexion 83 comprenant un empilement 84 de couches isolantes et des pistes conductrices 86 de différents niveaux de métallisation, des pistes conductrices 86 de deux niveaux de métallisation étant représentées à titre d'exemple en figure 21, et des vias conducteurs 88 s'étendant au travers de l'empilement 84 de couches isolantes, de la couche isolante 68, et de la couche isolante 74, et connectant la couche d'électrode 76 aux pistes conductrices 86, la structure d'interconnexion 83 présentant une face libre 90 de préférence plane.

La figure 22 est une vue en coupe, partielle et schématique, de la structure obtenue après une étape de fixation du substrat 21 à la face 90, par exemple par collage moléculaire.

La figure 23 est une vue en coupe, partielle et schématique, de la structure obtenue les étapes suivantes :
- retrait de la poignée 82 par tout moyen connu ;
- gravure de la couche isolante 80 au niveau de certains ensembles de diodes électroluminescentes LED pour exposer ces ensembles de diodes électroluminescentes, et entre les ensembles de diodes électroluminescentes LED, la couche isolante 80 étant conservée pour les autres ensembles de diodes électroluminescentes LED ;
- formation de blocs photoluminescents 94, 96 recouvrant les ensembles de diodes électroluminescentes exposées LED, deux blocs photoluminescents 94, 96 étant représentés à titre d'exemple en figure 23 ;

- formation de murs 98 réfléchissants entre les blocs 94, 96 ;
- formation d'une couche d'encapsulation 100 recouvrant chaque bloc 94, 96, et la couche diélectrique de protection 78 entre les blocs 94, 96, la couche d'encapsulation 100 comprenant les parties non gravées de la couche isolante 80 ; et
- formation, dans la couche d'encapsulation 100, d'au moins un filtre de couleur 102, par exemple un seul filtre jaune, recouvrant au moins certains des blocs photoluminescents 94, 96, un seul filtre 102 recouvrant les deux blocs photoluminescents 94, 96 étant représentés à titre d'exemple en figure 23.

La structure reposant sur le substrat 21 forme la plaque 20 décrite précédemment et la face libre 23 de la couche d'encapsulation 100 correspond à la face 23 décrite précédemment.

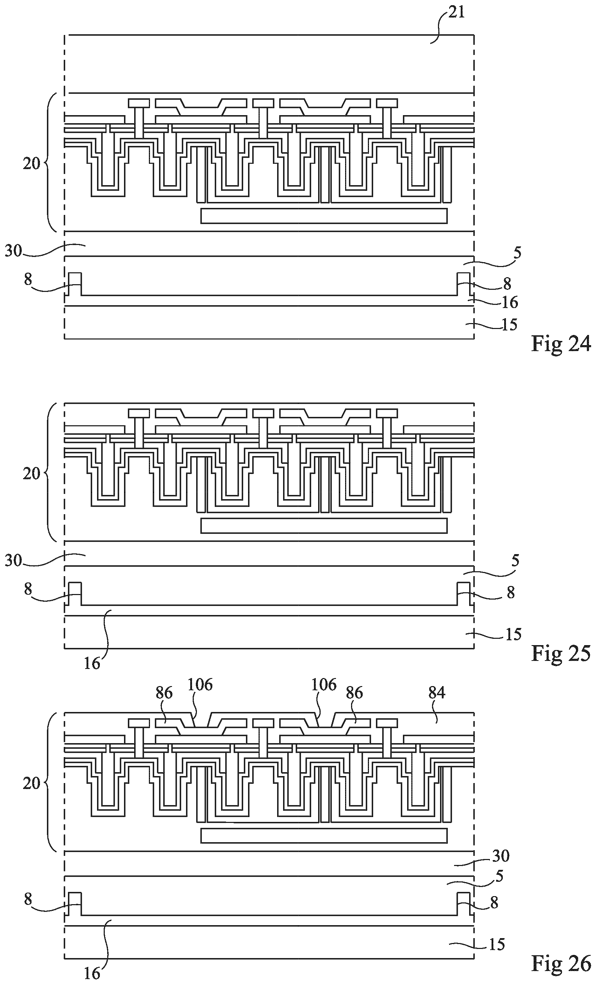

La figure 24 est une vue en coupe, partielle et schématique, illustrant l'étape décrite précédemment en relation avec la figure 5 comprenant la fixation par collage de la face 23 de la plaque 20 à la première poignée 5 par la couche de colle 30. En figure 24, la première poignée 5 est représentée ici avec deux rainures 8.

La figure 25 est une vue en coupe, partielle et schématique, illustrant l'étape décrite précédemment en relation avec la figure 6 comprenant le retrait du substrat 21.

La figure 26 est une vue en coupe, partielle et schématique, de la structure obtenue après une étape de formation d'ouvertures 106 dans l'empilement 84 de couches isolantes pour exposer des pistes conductrices 86.

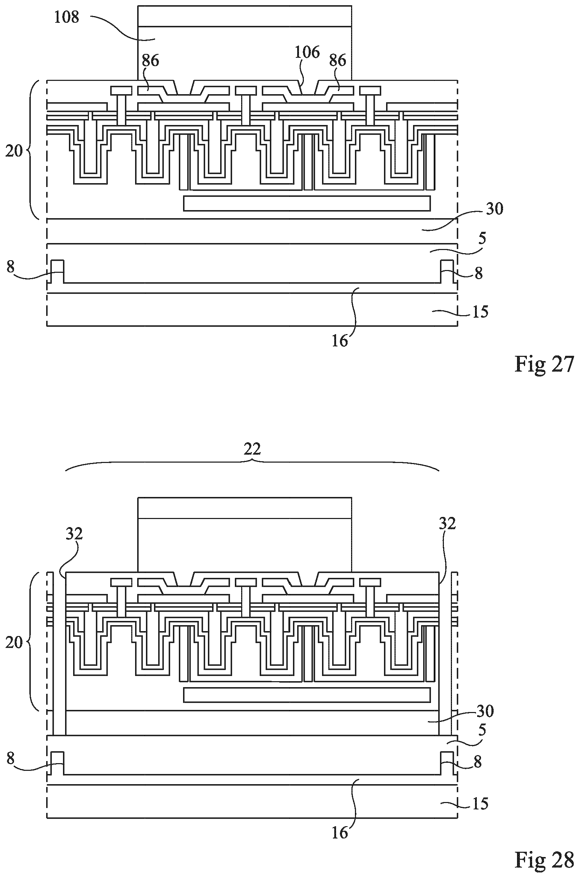

La figure 27 est une vue en coupe, partielle et schématique, de la structure obtenue après une étape de formation de plots conducteurs 108 au contact des pistes conductrices 86 exposées au travers des ouvertures 106, un seul plot conducteur 108 étant représenté à titre d'exemple en figure 27. Chaque plot conducteur 108 peut avoir une structure monocouche ou multicouche.

La figure 28 est une vue en coupe, partielle et schématique, illustrant l'étape décrite précédemment en relation avec la figure 7 comprenant la gravure de tranchées 32 dans la plaque 20 au niveau des lignes de séparation souhaitées des dispositifs électroniques 22.

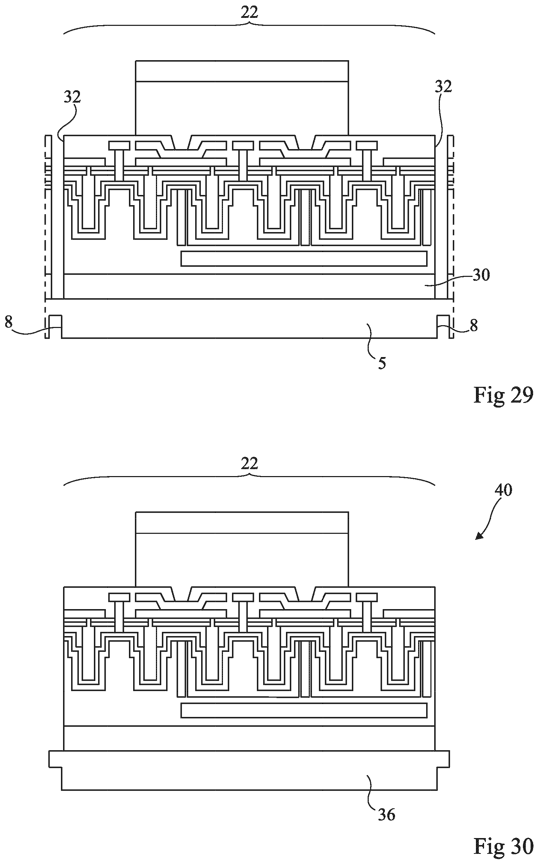

La figure 29 est une vue en coupe, partielle et schématique, illustrant l'étape décrite précédemment en relation avec la figure 9 comprenant le retrait de la deuxième poignée 15 et de la couche de colle 16.

La figure 30 est une vue en coupe, partielle et schématique, illustrant l'étape décrite précédemment en relation avec la figure 10 comprenant la rupture de la première poignée 5 au niveau des rainures 8 pour séparer les dispositifs optoélectroniques 22.

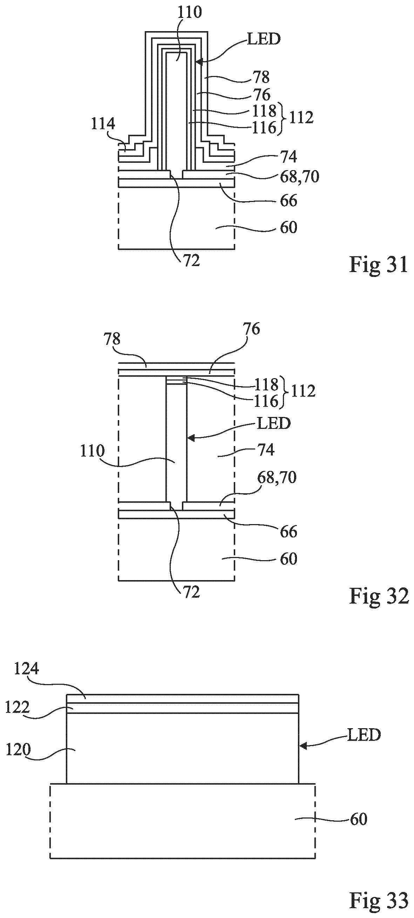

La figure 31 représente un mode de réalisation des diodes électroluminescentes LED. Selon un mode de réalisation, chaque diode électroluminescente LED comprend un fil 110 en contact avec la couche de germination 66 au travers de l'une des ouvertures 72 et une coque 112 comprenant un empilement de couches semiconductrices recouvrant les parois latérales et le sommet du fil 110. Une telle configuration est dite radiale. L'ensemble formé par chaque fil 110 et la coque 112 associée constitue la diode électroluminescente LED. En figure 31, on a en outre représenté une couche réfléchissante 114, par exemple métallique, recouvrant la couche d'électrode 76 entre les fils 110 et en contact physique direct avec la couche d'électrode 76.

La coque 112 peut comprendre un empilement de plusieurs couches comprenant notamment une couche active 116 et une couche de liaison 118. La couche active 116 est la couche depuis laquelle est émise la majorité, de préférence la totalité, du rayonnement fourni par la diode électroluminescente LED. Selon un exemple, la couche active 116 peut comporter des moyens de confinement, tels qu'un puits quantique unique ou des puits quantiques multiples. La couche de liaison 118 peut comprendre un empilement de couches semiconductrices du même matériau III-V que le fil 110 mais du type de conductivité opposé au fil 110.

La figure 32 représente un mode de réalisation des diodes électroluminescentes LED. La diode électroluminescente LED représentée en figure 32 comprend l'ensemble des éléments de la diode électroluminescente LED représentée en figure 31 à la différence que la coque 112 n'est présente qu'au sommet du fil 110. Une telle configuration est dite axiale.

La formation des diodes électroluminescentes LED, c'est-à-dire la croissance des fils 110 dans les ouvertures 72, et la formation des coques 112 recouvrant les fils 110 peut être réalisée par exemple par dépôt chimique en phase vapeur organométallique (MOCVD, acronyme anglais pour Metal-Organic Chemical Vapor Déposition) ou tout autre procédé adapté.

La couche de germination 66 est en un matériau favorisant la croissance des fils. A titre d'exemple, le matériau composant la couche de germination 66 peut être un nitrure, un carbure ou un borure d'un métal de transition de la colonne IV, V ou VI du tableau périodique des éléments ou une combinaison de ces composés

Selon un autre mode de réalisation, la couche de germination 66 peut ne pas être présente. Selon un autre mode de réalisation, la couche de germination 66 peut être remplacée par des plots de germination, par exemple formés au fond des ouvertures 72.

La figure 33 représente un mode de réalisation des diodes électroluminescentes LED. La diode électroluminescente LED représentée en figure 33 a une structure bidimensionnelle dans la mesure où elle est fabriquée par la formation d'un empilement de couches semiconductrices sensiblement planes sur le substrat 60 suivie de la délimitation de la diode électroluminescente, par exemple par gravure de tranchées dans l'empilement de couches semiconductrices. La diode électroluminescente représentée en figure 33 comprend une couche semiconductrice 120 dopée d'un premier type de conductivité, recouverte d'une couche active 122, elle-même recouverte d'une couche semiconductrice 124 dopée d'un deuxième type de conductivité.

Le substrat 60 peut correspondre à une structure monobloc ou correspondre à une couche recouvrant un support constitué d'un autre matériau. Le substrat 60 est de préférence un substrat semiconducteur, par exemple un substrat en silicium, en germanium, en carbure de silicium, en un composé III-V, tel que du GaN ou du GaAs, ou un substrat en ZnO. De préférence, le substrat 60 est un substrat de silicium monocristallin. Le substrat 60 peut correspondre à une structure multicouches de type silicium sur isolant, également appelée SOI (acronyme anglais pour Silicon On Insulator) .

Chaque couche isolante 68, 70, 74, 78, 80, et la couche d'encapsulation 100 peut être en un matériau diélectrique, par exemple en oxyde de silicium (SiO₂), en nitrure de silicium (SiₓN_{y}, notamment avec x et y environ égaux à 1, par exemple du SiN, ou avec x environ égal à 3 et y environ égal à 4, par exemple du Si₃N₄), en oxynitrure de silicium (notamment de formule générale SiOₓN_{y}), en oxyde d'aluminium (Al₂O₃), en oxyde d'hafnium (HfO₂), en dioxyde de titane (TiO₂) ou en diamant. Chaque couche isolante 68, 70, 74, 78, 80 peut avoir une structure monocouche ou correspondre à un empilement de deux couches ou de plus de deux couches.

La couche d'électrode 76 est adaptée à laisser passer le rayonnement électromagnétique émis par les diodes électroluminescentes. Le matériau formant la couche d'électrode 76 peut être un matériau transparent et conducteur tel que de l'oxyde d'indium-étain (ou ITO, acronyme anglais pour Indium Tin Oxide), ou de l'oxyde de zinc dopé à l'aluminium ou au gallium. L'épaisseur de la couche d'électrode 76 peut être comprise entre 0,01 µm et 1 µm.

Selon un mode de réalisation, chaque bloc photoluminescent 94, 96 est situé en vis-à-vis de l'une des diodes électroluminescentes ou d'un ensemble de diodes électroluminescentes. Chaque bloc photoluminescent 94, 96 comprend des luminophores adaptés, lorsqu'ils sont excités par la lumière émise par la diode électroluminescente LED associée, à émettre de la lumière à une longueur d'onde différente de la longueur d'onde de la lumière émise par la diode électroluminescente LED associée.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

## Revendications

1. Procédé de fabrication d'un dispositif électronique (22), comprenant les étapes suivantes :
- formation, dans une première poignée (5) ayant des première et deuxième faces opposées (6, 7), de rainures (8) dans la première face (6) ;
- fixation de la première poignée (5) à une deuxième poignée (15) du côté de la première face (6) ;
- amincissement de la première poignée (5) du côté de la deuxième face (7) ;
- fabrication d'une plaque (20) comprenant plusieurs exemplaires du dispositif électronique (22) ;
- fixation de la plaque (20) à la deuxième face (7) de la première poignée (5) ;
- formation de tranchées (32) dans la plaque (20) dans le prolongement des rainures (8) ;
- retrait de la deuxième poignée (15) ; et
- rupture de la première poignée (5) au fond des rainures (8) pour séparer les dispositifs électroniques (22).

2. Procédé selon la revendication 1, dans lequel les rainures (8) sont formées par gravure par laser.

3. Procédé selon la revendication 1 ou 2, dans lequel la fixation de la première poignée (5) à la deuxième poignée (15) est réalisée par collage par une première couche de colle (16).

4. Procédé selon la revendication 3, dans lequel l'étape de retrait de la deuxième poignée (15) comprend en outre une étape de retrait, total ou partiel, de la première couche de colle (16).

5. Procédé selon l'une quelconque des revendications 1 à 4, dans lequel la fixation de la plaque (20) à la première poignée (5) est réalisée par collage par une deuxième couche de colle (30).

6. Procédé selon l'une quelconque des revendications 1 à 3, dans lequel la fixation de la plaque (20) à la première poignée (5) est réalisée par collage moléculaire.

7. Procédé selon l'une quelconque des revendications 1 à 6, dans lequel les tranchées (32) sont formées par gravure de la plaque (20) par gravure sèche ou gravure humide.

8. Procédé selon l'une quelconque des revendications 1 à 7, dans lequel l'étape de fixation de la plaque (20) à la première poignée (5) comprend une étape de positionnement de premières marques de la première poignée (5) par rapport à des deuxièmes marques de la plaque (20), de sorte que chaque dispositif électronique (22) à séparer est positionné entre quatre rainures (8) parmi les rainures (8).

9. Procédé selon l'une quelconque des revendications 1 à 8, dans lequel la première poignée (5) est au moins en partie en verre, en quartz, ou en saphir.

10. Procédé selon l'une quelconque des revendications 1 à 9, dans lequel, en projection dans un plan parallèle à la deuxième face (7), l'une des rainures (8) est située entre chaque paire de dispositifs électroniques (22) adjacents.

11. Structure comprenant :
- une première poignée (5) ayant des première et deuxième faces (6, 7) et des rainures (8) dans la première face (6) ;
- une plaque (20) comprenant plusieurs exemplaires d'un dispositif électronique (22) fixée à la première poignée du côté de la deuxième face (7) ; et
- une deuxième poignée (15) fixée à la première poignée (5) du côté de la première face (6).

12. Structure selon la revendication 11, comprenant en outre une première couche de colle (16) entre la première poignée (5) et la deuxième poignée (15).

13. Structure selon la revendication 11 ou 12, comprenant en outre une deuxième couche de colle (30) entre la plaque (20) et la première poignée (5).

14. Structure selon l'une quelconque des revendications 11 à 13, dans laquelle les rainures (8) délimitent des plots (11) dans la première poignée (5), chaque plot (11) étant en regard d'un seul des dispositifs électroniques (22) .

15. Système électronique (40) comprenant un dispositif électronique (22) ayant une première paroi latérale (34) et un bloc (36) ayant des première et deuxième faces opposées (6, 7) et une deuxième paroi latérale (10), le dispositif électronique (22) étant fixé à la deuxième face (7), le système électronique (40) comprenant en outre des flancs (41) contenant la première paroi latérale (34), la deuxième paroi latérale (10) et une partie (42) reliant la première paroi latérale (34) à la deuxième paroi latérale (10) en saillie par rapport à la première paroi latérale (34) et par rapport à la deuxième paroi latérale (10).

16. Système électronique selon la revendication 15, dans lequel le dispositif électronique (22) comprend des diodes électroluminescentes (LED).

17. Système électronique selon la revendication 16, dans lequel chaque diode électroluminescente (LED) comprend un élément tridimensionnel semiconducteur (110) de taille nanométrique ou micrométrique, correspondant à un microfil, un nanofil ou une structure de taille nanométrique ou micrométrique de forme pyramidale, et une couche active (112) recouvrant l'élément tridimensionnel semiconducteur (110) .
